# EUROPEAN PATENT SPECIFICATION

(11) **EP 2 447 986 B1**
(45) Date of publication and mention of the grant of the patent: **04.06.2014**
(21) Application number: 11186409.6
(22) Date of filing: 24.10.2011
(51) Int. Cl.: H01L 21/56, H01L 23/31, B29C 45/14, H01L 21/67

(54) **Resin encapsulation molding method and apparatus for electrical circuit component**
Harzformverfahren zur Verkapselung und Vorrichtung für elektrische Schaltkomponente
Procédé de moulage d'encapsulation de résine et appareil pour composant de circuit électrique

(30) Priority: 02.11.2010 JP 2010245906
(43) Date of publication of application: 02.05.2012
(73) Proprietor: Towa Corporation, Kyoto-shi, Kyoto 601-8105 (JP)
(72) Inventor: Tane, Yukitomo, Kyoto 601-8105 (JP); Koba, Yuichi, Kyoto 601-8105 (JP); Ogawa, Yukihiro, Kyoto 601-8105 (JP)
(74) Representative: Lipscombe, Martin John

(56) References cited:
- EP-A2- 0 257 681
- WO-A1-2010/038660
- US-A- 5 384 286
- US-A1- 2003 180 985
- US-A1- 2004 166 605

## Description

### BACKGROUND OF THE INVENTION

### Field of the Invention

The present invention relates to a resin encapsulation method for an electrical circuit component and a resin encapsulation apparatus for an electrical circuit component. The present invention particularly relates to a resin encapsulation method for an electrical circuit component to encapsulate, with a resin material, electrical circuit components that include a resin molded connector part and a substrate and a metal external connection terminal, and to mold the encapsulating resin material and a resin encapsulation apparatus for an electrical circuit component used in the method.

### Description of the Background Art

As an electronic control device to be equipped in a vehicle, for example, an electronic control device for an engine may be mounted within an engine room, and a control device for an automatic transmission may be mounted on an automatic transmission. In this case, it is necessary for electronic components or the like implemented on a substrate to be housed in a case for the protection of the electronic control device, because, for example, the electronic control device for the engine and the control device for the automatic transmission are installed in a high or low temperature environment or fouled with water and oil.

To this end, it has been practiced to implement electronic components on a substrate and electrically connect the substrate and an external connection terminal together, and then to integrally encapsulate the entire substrate with a resin material and mold the encapsulating resin material.

Resin molding technologies such as transfer molding are employed as a technology of encapsulating the entire substrate with a resin material and molding the encapsulating resin material as above. In this case, it is necessary for the entire substrate to be arranged at a predetermined position in a mold for transfer molding. To this end, in a patent literature, Japanese Patent Laying-Open No. 2003-37241, for example, the entire substrate is attached onto a lead frame in advance, and the lead frame is then arranged within a cavity of a mold for transfer molding, thereby allowing the entire substrate to be arranged at a predetermined position in the cavity.

With the above-described electric control device to be equipped in a vehicle, use of the lead frame enables that in encapsulating the entire substrate with a resin material and molding the encapsulating resin material, the entire substrate attached onto the lead frame is arranged at a predetermined position in a cavity of a mold for resin molding by means of that lead frame.

Similarly US 2003/0180985 discloses a resin molding method for a semiconductor device, in which method the respective cavities of upper and lower mold blocks face each other when clamped together, and a lead frame, a semiconductor chip connected to the lead frame and a nut, overlapping and provided on a terminal portion of the lead frame, are integrally molded with a seal resin that is injected into the cavities in the mold block, and upper and lower sides of the nut are formed to be resin-tight structures by pressure from elastic bodies.

US 5,384,286 discloses a method and apparatus for producing a semiconductor device using a heat-sinking frame and a lead frame. The heat-sinking frame and lead frame are precisely positioned on a lower mold with co-operating positioning holes and pins with a space between the heat-sinking frame and the lead frame. After an upper mold is clamped to the lower mold, resin is injected into a cavity in the mold to encapsulate the lead frame (to which a semiconductor chip is attached) and the heat-sinking frame within one body.

EP 0,257,681 discloses another method for manufacturing an encapsulated semiconductor device. In the method, correct positioning of the metallic plate supporting the semiconductor chips in the mold used for encapsulation achieved by using at least one pair of locating pins and by locators present in the mold referenced to the lead connected to the plate. The ends of the locating pins are spaced, in the final phase of encapsulation, with respect to the surfaces of the plate, whereas in the initial phase they are directly connected to the metallic surfaces or indirectly connected through the interposition of insulating thicknesses.

W2010/038660 discloses a method and apparatus for resin encapsulation of an electronic component. A top force and a bottom force of a resin sealing compression molding device are equipped, respectively, with cooling means. A gate nozzle equipped with a cooling means is provided in the top force. The bottom force is provided with a cavity in which the single sheet of substrate is loaded. In this device, a predetermined quantity of liquid thermosetting resin material is supplied in to cavity through the gate nozzle. Thereafter, a substrate is supplied between the top force and bottom force, which are then clamped. Consequently, an electronic component on the substrate is immersed in the liquid thermosetting resin material in the cavity. The temperature of the liquid thermosetting resin material is controlled by the gate nozzle and the cooling means.

US2004/166605 discloses a method of manufacturing a semiconductor integrated circuit device. The method utilises a mold which is provided with a plurality of air vents and moveable pins which include grooves in distal ends thereof and project into the air vents. By clamping the mold so that the distal ends of the moveable pins are pushed to a multi-cavity board at the time of clamping the mold, resin can be filled while leaking air inside the cavity through the grooves in the ends of the moveable pins by setting the depths of the respective air vents to a fixed value irrespective of the irregularities of thicknesses of multi-cavity boards. The method aims to prevent the occurrence of insufficient filling of resin in the cavity, the occurrence of leaking resin and/or defective welding.

### SUMMARY OF THE INVENTION

However, a substrate which does not use the above-described lead frame has the following problems when the entire substrate is encapsulated with a resin material and the encapsulating resin material is molded. For example, when each component of an electronic control device, which includes a resin molded connector part and a glass epoxy substrate and a metal external connection terminal to be connected to a battery equipment, is individually arranged at a predetermined position in a cavity of a mold for resin molding, the operation of arranging each of the components will be difficult and inefficient. In addition, if it is not ensured that each component is arranged at the predetermined position in the cavity of the mold for resin molding, encapsulating the components with a resin material and molding the encapsulating resin material cannot be performed efficiently and reliably.

This causes part of the resin material to adhere to a surface of the external connection terminal protruding from a resin encapsulation molded body, which encapsulates the electronic control device and has been molded. As a result, a resin flash is formed, leading to occurrence of problems such as the impaired electrical connectability of the electric control device.

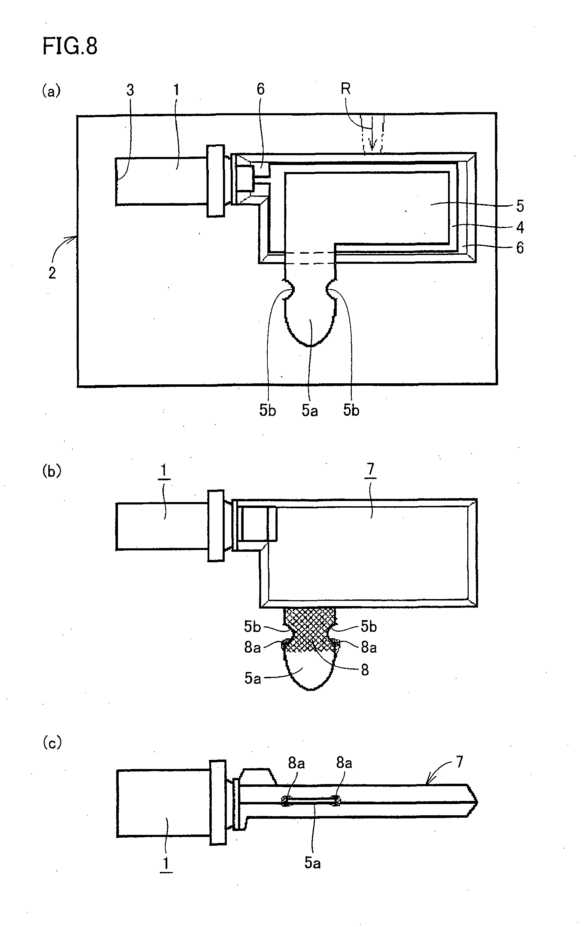

For example, as shown in Fig. 8 (a), when a resin molded connector part 1 is arranged in a cavity to be fitted with 3 provided in a mold surface of a mold for resin molding 2, and a glass epoxy substrate 4, a metal external connection terminal 5 and the like which are electrically connected to connector part 1 are arranged in a molding cavity 6 provided in the mold surface, if it is not ensured that each of the above-described components is arranged at a predetermined position in each cavity, then a failure will occur in mold matching of mold for resin molding 2 (mold clamping operation).

In this state, if one tries to mold a resin encapsulated body corresponding to the shape of molding cavity 6 by injecting a thermosetting melted resin material (flowable resin) R into the molding cavity and filling the molding cavity, then a resin flash 8 is formed on a surface of terminal 5a protruding from the resin encapsulated body 7, as shown in Fig. 8 (b) and Fig. 8 (c), and its electrical connectability will be impaired. In particular, a resin lump (set resin) 8a may adhere to, and become one piece with, a constricted portion 5b of the external connection terminal. This causes a serious problem of the impaired attachability/detachability to/from other equipment to be connected to terminal 5a.

The present invention has been made to solve the problems above, and one object of the invention is to provide a resin encapsulation method for an electrical circuit component which prevents a resin flash from being formed by ensuring, without using a lead frame, that each component of electrical circuit components that include a resin molded connector part and a substrate and a metal external connection terminal electrically connected to the connector part is arranged at a predetermined position in a cavity of a mold for resin molding. Another object of the invention is to provide a resin encapsulation apparatus for an electrical circuit component used in such a resin encapsulation method for an electrical circuit component.

A resin encapsulation method according to the present invention for encapsulating with a resin material (R) a substrate and an external connection terminal and for integrally connecting a resin molded article with a resin encapsulated body, said resin encapsulated body comprising said substrate and said external connection terminal, said external connection terminal being electrically connected to said resin molded article, comprises the steps of providing a mold for resin molding comprising a top mold and a bottom mold; fitting said resin molded article into a cavity provided in a mold surface of said bottom mold and fitting said substrate and said external connection terminal into a molding cavity provided in the mold surface of said bottom mold, said resin molded article, on the one hand, and said substrate and said external connection terminal, on the other hand, being individually arranged in the cavity and the molding cavity respectively; guiding said article to a predetermined position in said cavity by means of a first guiding member provided at said bottom mold and guiding said substrate and said external connection terminal to a predetermined position in said molding cavity by means of a second guiding member provided at said bottom mold; using two fixing members provided at said bottom mold to support said external connection terminal, by guiding said external connection terminal to a predetermined position in said bottom mold and by pressing a constricted portion formed on a lateral surface of said external connection terminal against said fixing members; clamping said top mold and said bottom mold, the top mold having a cavity and a molding cavity opposite to the cavity and the molding cavity of the bottom mold; encapsulating said substrate and said external connection terminal fitted into said molding cavity, by injecting said resin material (R) into said molding cavity formed by the mold clamping of said top mold and said bottom mold to fill said molding cavity in a manner to form said resin encapsulated body encapsulating said substrate and said external connection terminal and to integrally connect said resin encapsulated body and said resin molded article so that a one-piece resin encapsulated molded article is formed; opening said mold and removing, from said mold, said resin encapsulated body and said molded article that have been made into one piece.

Preferably, the step of clamping the mold for resin molding includes the step of bringing a pressing surface of a pressing member provided at the mold for resin molding into contact with a surface of the external connection terminal, by means of elastic force.

In a second aspect, the invention provides a resin encapsulation apparatus for encapsulating with a resin material (R) a substrate and an external connection terminal and for integrally connecting a resin molded article with a resin encapsulated body, said resin encapsulated body comprising said substrate and said external connection terminal, said external connection terminal being electrically connected to said resin molded article, the apparatus being equipped with a mold for resin molding, a bottom mold with a cavity and a molding cavity and a top mold having a cavity and a molding cavity opposite to the cavity and the molding cavity of the bottom mold; said mold for resin molding comprising: the cavity between the bottom mold and the top mold to be fitted with said resin molded article; the molding cavity between the bottom mold and the top mold to be fitted with said substrate and said external connection terminal; a first guiding member to guide said article to a predetermined position in said cavity; a second guiding member to guide said substrate and said external connection terminal to a predetermined position in said molding cavity; and a pressing and supporting part including two fixing members provided at said bottom mold and extending above the mold surface of said bottom mold supporting said external connection terminal by pressing a constricted portion formed on a lateral surface of said external connection terminal against said fixing members.

Preferably, the mold for resin molding includes a first pressing member having a pressing surface which comes into contact with a surface of the external connection terminal by means of elastic force.

Preferably, the mold for resin molding includes a second pressing member having a pressing surface which comes into contact with a back surface of said external connection terminal by means of elastic force.

With the resin encapsulation molding method for an electrical circuit component or the resin encapsulation molding apparatus for an electrical circuit component according to the present invention, first, each component can be efficiently and reliably fitted into a predetermined cavity (the cavity, or the molding cavity) in the mold for resin molding because the article can be guided via the first guiding member to the cavity, and the substrate and the external connection terminal can be guided via the second guiding member to the molding cavity.

In addition, after fitting each component into a predetermined cavity, it can be ensured that the external connection terminal is arranged at a predetermined position by causing the fixing member to support the external connection terminal, through guiding the external connection terminal to a predetermined position and through pressing the constricted portion formed on opposing lateral surfaces of the external connection terminal against the fixing member.

At this time, since it can be ensured that the external connection terminal is arranged at a predetermined position, it can be ensured that a mold for resin molding is clamped. This ensures that the encapsulating melted resin material (flowable resin) is prevented from flowing out of the mold surface of the mold for resin molding to the outside of the cavity and adhering to a surface of the external connection terminal, causing a resin flash to be formed.

Further, since the constricted portion of the external connection terminal is supported by the fixing member, even if part of the encapsulating melted resin material flows out of the mold surface of the mold for resin molding to the outside of the cavity, the resin is prevented from adhering to the constricted portion. Therefore, it can be ensured that a resin flash is prevented from being formed on the constricted portion.

In addition, by bringing the pressing surface of the pressing member (the first pressing member, the second pressing member) provided at the mold for resin molding into contact with a surface of the external connection terminal, it can be further ensured that a resin flash is prevented from being formed on the front surface of the external connection terminal, as well as the back surface of the external connection terminal.

In this way, the resin encapsulation method for an electrical circuit component or the resin encapsulation apparatus for an electrical circuit component according to the present invention can ensure, without using a lead frame, that each component is fitted into a predetermined cavity even when each component of electrical circuit components that include a connector part (article) and a substrate and a metal external connection terminal electrically connected to the connector part is individually and directly fitted into a predetermined cavity (the cavity and the molding cavity respectively) in a mold for resin molding. In addition, the resin encapsulation method for an electrical circuit component or the resin encapsulation apparatus for an electrical circuit component according to the present invention can efficiently and reliably prevent a resin flash from being formed through adhesion of part of a resin material to a constricted portion of or a surface of the external connection terminal which protrudes from the resin encapsulated body made into one piece with the connector part.

The foregoing and other objects, features, aspects and advantages of the present invention will become more apparent from the following detailed description of the present invention when taken in conjunction with the accompanying drawings.

### BRIEF DESCRIPTION OF THE DRAWINGS

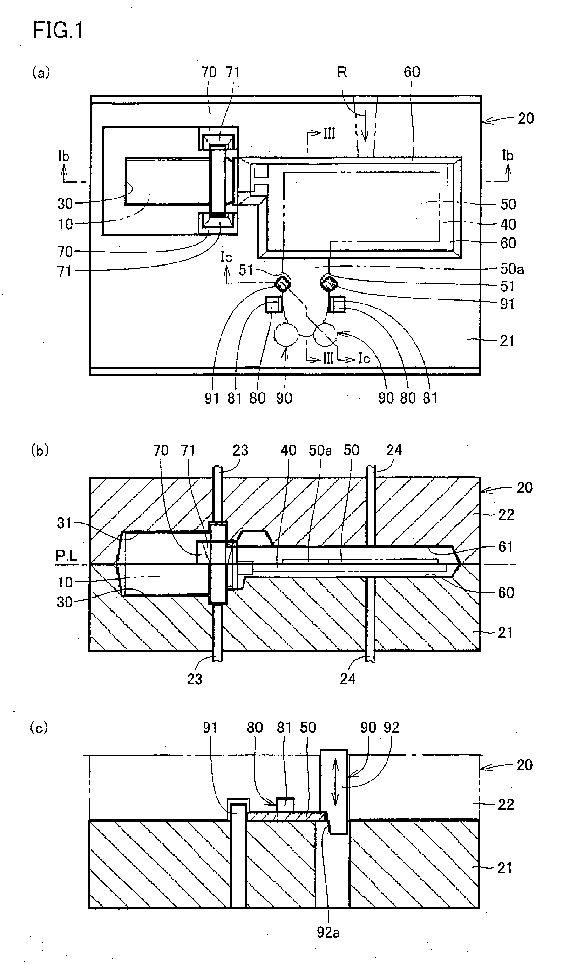

Fig. 1 (a)-(c) shows a resin encapsulation molding apparatus for an electrical circuit component according to a first embodiment. Fig. 1 (a) is a plan view schematically showing a mold surface of a bottom mold in the resin encapsulation apparatus. Fig. 1 (b) is a vertical cross sectional view taken along a line Ib-Ib in Fig. 1 (a) and schematically showing a top mold and a bottom mold. Fig. 1 (c) is a vertical cross sectional view taken along a line Ic-Ic in Fig. 1 (a) and schematically showing the bottom mold.

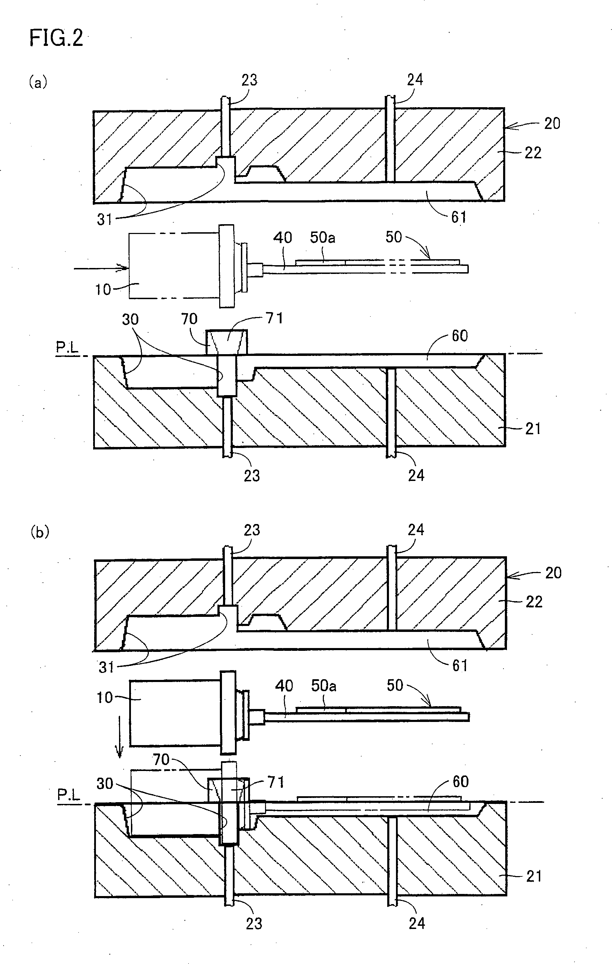

Fig. 2 (a)-(b) is a vertical cross sectional view corresponding to Fig. 1 (b) and schematically showing the top and bottom molds in the same embodiment. Fig. 2 (a) is a vertical cross sectional view showing a state in which the top and bottom molds are opened. Fig. 2 (b) is a vertical cross sectional view showing a state in which the top and bottom molds are opened.

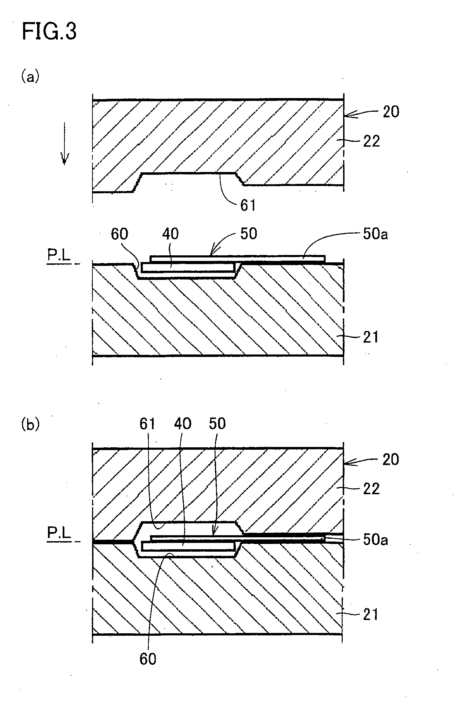

Fig. 3 (a)-(b) is a vertical cross sectional view taken along a line III-III in Fig. 1 (a) and schematically showing the top and bottom molds in the same embodiment. Fig. 3 (a) is a vertical cross sectional view showing a state in which the top and bottom molds are opened. Fig. 3 (b) is a vertical cross sectional view showing a state in which the top and bottom molds are clamped together.

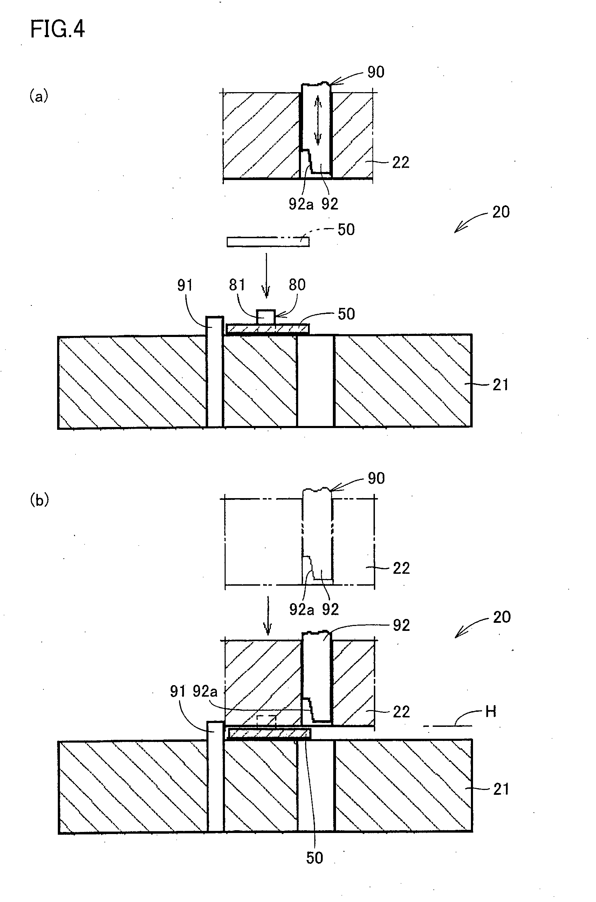

Fig. 4 (a)-(b) is a vertical cross sectional view taken along a line Ic-Ic in Fig. 1 (a) and schematically showing the top and bottom molds in the same embodiment. Fig. 4 (a) is a vertical cross sectional view showing a state in which the top and bottom molds are opened. Fig. 4 (b) is a vertical cross sectional view showing a state just before the top and bottom molds are clamped together.

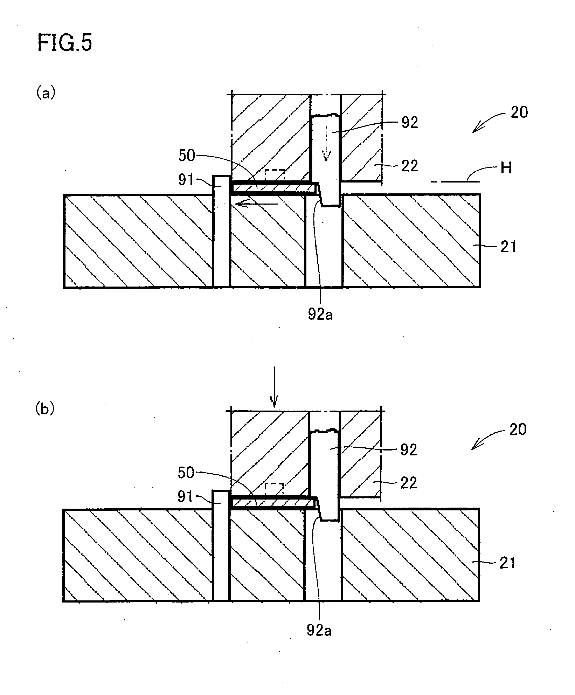

Fig. 5 (a)-(b) is a vertical cross sectional view corresponding to Fig. 4 (b) and schematically showing the top and bottom molds in the same embodiment. Fig. 5 (a) is a first vertical cross sectional view for illustrating the step of arranging an external connection terminal at a predetermined position. Fig. 5 (b) is a second vertical cross sectional view for illustrating the step of arranging an external connection terminal at a predetermined position.

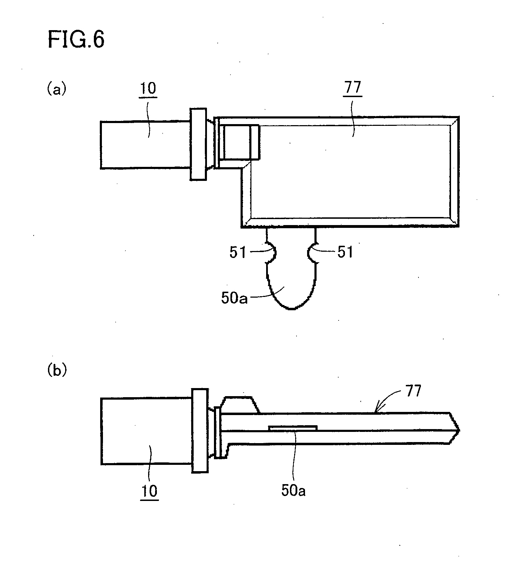

Fig. 6 (a)-(b) shows a resin encapsulated article encapsulating electrical circuit components with a resin material in the same embodiment. Fig. 6 (a) is a plan view of the resin encapsulated article. Fig. 6 (b) is a front view of the resin encapsulated article.

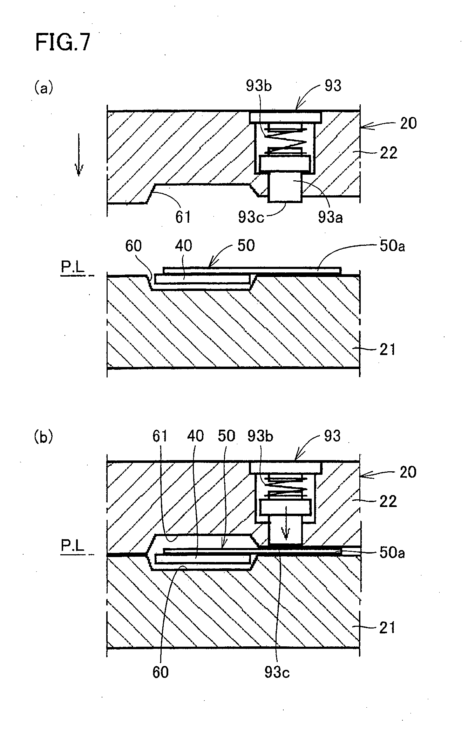

Fig. 7 (a)-(b) shows a resin encapsulation apparatus for an electrical circuit component according to a second embodiment. Fig. 7 (a) is a vertical cross sectional view corresponding to Fig. 3 and showing a state in which the top and bottom molds are opened. Fig. 7 (b) is a vertical cross sectional view corresponding to Fig. 3 showing a state in which the top and bottom molds are clamped together.
Fig. 8 (a)-(c) is a diagram for illustrating the background art. Fig. 8 (a) is a plan view schematically showing a mold surface of a bottom mold in a resin encapsulation apparatus. Fig. 8 (b) is a plan view of a resin encapsulated article molded by the resin encapsulation apparatus. Fig. 8 (c) is a front view of the resin encapsulated molded article by the resin encapsulated apparatus.

### DESCRIPTION OF THE PREFERRED EMBODIMENTS

A resin encapsulation apparatus according to a first embodiment of the present invention will be hereinafter described with reference to Figs. 1-6.

### First Embodiment

Fig. 1 shows the main parts of a resin encapsulation apparatus for an electrical circuit component according to the first embodiment of the present invention. This resin encapsulation apparatus is equipped with a mold for resin molding 20 for encapsulating with a resin material and integrally molding electrical circuit components made up of a plurality of components that include an article (connector part) 10 and a glass epoxy substrate 40 and a metal external connection terminal 50 to be connected to a battery equipment which are electrically connected to the article.

A bottom mold 21 in mold for resin molding 20 has a mold surface in which a cavity 30 to be fitted with the lower half of resin molded article 10 and a molding cavity 60 to be fitted with the lower halves of glass epoxy substrate 40 and external connection terminal 50 are provided.

In addition, the mold surface of bottom mold 21 is provided with a guiding member 70 for guiding article 10 to a predetermined position in cavity 30 and a guiding member 80 for guiding glass epoxy substrate 40 and external connection terminal 50 to molding cavity 60. Guiding member 70 has a tapered surface 71 formed thereon. Guiding member 80 has a tapered surface 81 formed thereon. In this mold for resin molding 20, guiding members 70 are arranged at two points in front of and at the rear of cavity 30, respectively, while guiding members 80 are arranged at two points on the right and left of external connection terminal 50 in a manner to adjoin opposing lateral surfaces of a tip end of external connection terminal 50, respectively.

Further, the mold surface of bottom mold 21 is provided with a pressing and supporting part 90 to support external connection terminal 50. Pressing and supporting part 90 presses a constricted portion 51, which is formed on each of the opposing lateral surfaces of external connection terminal 50, against a fixing member 91 provided at a predetermined position at bottom mold 21, thereby causing fixing member 91 to support external connection terminal 50. In this mold for resin molding 20, fixing members 91 are arranged at two points on the right and left on bottom mold 21 corresponding to the positions of right and left constricted portions 51, respectively.

Above bottom mold 21, a top mold 22 is arranged opposite bottom mold 21, as shown in Fig. 1 (b). Bottom mold 21 and top mold 22 are arranged in a manner to enable opposing mold surfaces of bottom mold 21 and top mold 22 to be joined together (brought into contact) and separated from each other. It is noted that in a resin molding process, when a mold surface of a top mold and a mold surface of a bottom mold are joined together as shown in Fig. 1 (b), it is called "mold clamping". On the other hand, when the mold surface of the top mold and the mold surface the bottom mold are separated from each other (see Fig. 2), it is called "mold opening".

In a portion of the mold surface of top mold 22 opposite cavity 30 of bottom mold 21, a cavity 31 which is to be fitted with the upper half of article 10 is provided.

Further, in a portion of the mold surface of top mold 22 opposite molding cavity 60 of bottom mold 21, a molding cavity 61 which is to be fitted with the upper halves of substrate 40 and external connection terminal 50 is provided.

Pressing and supporting part 90 of external connection terminal 50 is provided so that when each component of the electrical circuit components is integrally resin encapsulated to mold a resin encapsulated body encapsulating an electrical circuit component, it is prevented that a resin lump (see resin lump 8a in Fig. 8) is formed through adhesion of part of an encapsulating melted resin material (flowable resin) to constricted portions 51 (see Fig. 6) formed on the opposing lateral surfaces of an external connection terminal 50a which will protrude from the resin encapsulated body.

As shown in Fig. 1 (c), pressing and supporting part 90 includes fixing member 91 provided on bottom mold 21 and a pushing-out member 92 for pushing external connection terminal 50 out toward fixing member 91.

As shown in Fig. 1 (a), fixing member 91 is provided at a position to be fitted to constricted portion 51 formed on each of the opposing lateral surfaces of external connection terminal 50. In this case, fixing members 91 are provided at predetermined positions at two points on the right and left on bottom mold 21 in a manner to correspond to the respective positions of constricted portions 51 at two points on the right and left of external connection terminal 50.

Pushing-out member 92 is arranged at a portion of top mold 22 in the vicinity of the tip of external connection terminal 50 arranged on the mold surface of bottom mold 21. In this case, pushing-out members 92 are arranged at positions at two points on the right and left on the top mold. Further, pushing-out member 92 is arranged to be able to move vertically in top mold 22. In a state just before bottom mold 21 and top mold 22 are clamped together, pushing pushing-out member 92 down results in that a bottom surface portion of pushing-out member 92 adjoins the tip end of external connection terminal 50, and a tapered surface 92a formed on the bottom surface portion pushes the tip end of external connection terminal 50 out toward fixing member 91.

It is noted that at this time, the right and left opposing lateral surfaces of external connection terminal 50 adjoin guiding members 80 arranged at two points on the right and left on bottom mold 21. This results in that external connection terminal 50 is smoothly slid toward fixing members 91, under the guide of guiding members 80 on the right and left thereof.

As shown in Fig. 1 (b), cavity to be fitted with 30, 31 of mold for resin molding 20 is provided with a protrusion pin 23. Molding cavity 60, 61 is provided with a protrusion pin 24.

In resin encapsulation molding, the component fitted into cavity 30, 31 is held at a predetermined height (position) by causing a tip end portion of protrusion pin 23 to protrude into cavity 30, 31, while the component fitted into molding cavity 60, 61 is held at a predetermined height (position) by causing a tip end portion of protrusion pin 24 to protrude into molding cavity 60, 61. In this way, protrusion pins 23, 24 can serve as a supporting pin for each component.

It is noted with this mold for resin molding, pushing-out member 92 of pressing and supporting parts 90 is shown as being arranged in a symmetrical pair (a multiple arrangement) on the top mold 22 at positions in front of right and left guiding members 80 provided at bottom mold 21. As the pushing-out member, one (single) pushing-out member may be provided, which is configured such that pushing the pushing-out member down results in that a bottom surface portion of the pushing-out member adjoins the tip end of the external connection terminal, and a tapered surface formed on the bottom surface portion pushes the tip end of external connection terminal out toward the fixing member.

Next, referring to Figs. 2-6, description will be given on a method of molding a resin encapsulated article (product) encapsulating an electrical circuit component, using the above-described mold for resin molding.

First, article (connector part) 10 is fitted into cavity 30 provided in the mold surface of bottom mold 21 of mold for resin molding 20, and glass epoxy substrate 40 and external connection terminal 50 are fitted into molding cavity 60 (the step of fitting a plurality of components).

In this step, as shown in Fig. 2 (a), a plurality of components may be introduced between opened top mold 22 and bottom mold 21 automatically with any suitable carrying device or manually.

The guiding member provided at the mold for resin molding then guides the article to a predetermined position in the cavity and guides the substrate and the external connection terminal to the molding cavity (the step of assisting the fitting of a plurality of components). It is noted that this step may be performed simultaneously with the step of fitting a plurality of components.

Tapered surface 71 of guiding member 70 provided at bottom mold 21 fits article 10 into cavity 30 and guides the lower half of article 10 to a predetermined position in cavity 30.

Tapered surface 81 of guiding member 80 provided at bottom mold 21 fits external connection terminal 50 into molding cavity 60 and guides the lower half of external connection terminal 50 to a predetermined position in molding cavity 60.

Here, if the structure of glass epoxy substrate 40 is one in which it is integrally connected to external connection terminal 50, then the above-described step of assisting the fitting of external connection terminal 50 causes glass epoxy substrate 40 to have its lower half fitted into molding cavity 60.

In contrast, if the structure of glass epoxy substrate 40 and external connection terminal 50 is one in which they are electrically connected but not made into one piece, then fitting article 10 into cavity 30 and fitting external connection terminal 50 into molding cavity 60 cause glass epoxy substrate 40 and external connection terminal 50 to sequentially have their respective lower halves fitted into molding cavity 60.

In fitting the lower half of external connection terminal 50 into molding cavity 60, as shown in Fig. 1 (a), two constricted portions 51, 51 of external connection terminal 50 enter a state of being fitted with two fixing members 91, 91 provided at the mold for resin molding (bottom mold 21).

External connection terminal 50 is then guided to a predetermined position, and two constricted portions 51, 51 of external connection terminal 50 are pressed against two fixing members 91, 91 so that external connection terminal 50 is supported by fixing members 91, 91 (the step of pressing and supporting an external connection terminal).

In the step of assisting the fitting of a plurality of components, as shown in Fig. 4 (a), two constricted portions 51, 51 of external connection terminal 50 are in a state of being fitted with two fixing members 91, 91 provided at mold for resin molding (bottom mold 21).

In this state, as shown in Fig. 4 (b), top mold 22 is lowered to a position H at which the mold surface of top mold 22 and the mold surface of bottom mold 21 are just before being joined together, i.e. mold clamping. At this time, external connection terminal 50 is not under any mold clamping pressure applied by the top mold and the bottom mold. Thus, pushing pushing-out member 92 down in this state results in that the bottom surface portion of the pushing-out member adjoins the tip end of external connection terminal 50, and tapered surface 92a formed on the bottom surface portion pushes external connection terminal 50 out toward fixing member 91, as shown in Fig. 5 (a).

This results in that external connection terminal 50 smoothly slides toward fixing member 91, under the guide of right and left guiding members 80 provided at bottom mold 21 and that right and left constricted portions 51 of external connection terminal 50 are pressed by right and left fixing members 91 provided at bottom mold 21. In this way, external connection terminal 50 is supported by fixing member 91.

The mold surface of top mold 22 and the mold surface of bottom mold 21 are then joined together (the step of clamping molds). Glass epoxy substrate 40 and external connection terminal 50 are then encapsulated with a resin material, and the resin material encapsulating glass epoxy substrate 40 and the like are molded (the step of resin encapsulating a substrate and an external connection terminal). A thermosetting melted resin material (flowable resin) R is injected into molding cavity 60, 61 (see Fig. 1 (a)) and fills molding cavity 60, 61. As a result, the resin material encapsulates glass epoxy substrate 40 and external connection terminal 50 which are fitted into the molding cavity, and the encapsulating resin material is molded. Through this step, a resin encapsulated body (solidified resin) encapsulating glass epoxy substrate 40 and external connection terminal 50 is formed, and the resin encapsulated body and resin molded article (connector part) 10 are connected integrally together, so that a resin encapsulated article is formed.

The mold surface of top mold 22 and the mold surface of bottom mold 21 are then separated from each other (the step of opening molds). The resin encapsulated article encapsulating an electrical circuit component is then removed from between top mold 22 and bottom mold 21 (the step of removing a product).

As shown in Fig. 6, in the resin encapsulated article encapsulating an electrical circuit component removed from the mold for resin molding, article (connector part) 10 and a resin encapsulated body 77 encapsulating the glass epoxy substrate and the external connection terminal are integrally connected together, so that they are made into one piece.

No resin lump or resin flash is formed on two constricted portions 51, 51 of and upper and lower surfaces of terminal 50a which protrudes from resin encapsulating molded body 77.

This is due to the facts in the step of resin encapsulation that external connection terminal 50 is supported by fixing member 91 with two constricted portions 51, 51 pressed by right and left fixing members 91, 91 provided at bottom mold 21 and that under a mold clamping pressure applied by top mold 22 and bottom mold 21, the upper surface of terminal 50a is in close contact with the mold surface of top mold 22 and the lower surface of terminal 50a is in close contact with the mold surface of bottom mold 21.

According to the above-described first embodiment, even in a case where each component of electrical circuit components including connector part (article) 10 and glass epoxy substrate 40 and metal external connection terminal 50 which are electrically connected to the connector part are directly fitted into a predetermined cavity (cavity, molding cavity) of mold for resin molding 20, it is ensured, without use of a lead frame, that each component is fitted into a predetermined cavity and arranged at a predetermined position. This allows to ensure that mold for resin molding 20 is clamped. Thus, it is prevented that part of a melted resin material flows out of the mold surface of the mold for resin molding to the outside of the cavity. As a result, a resin flash is efficiently and reliably prevented from being formed on constricted portion 51 of and a surface of terminal 50a which protrudes from the resin encapsulated body of the resin encapsulated article.

Next, referring to Fig. 7, a resin encapsulation apparatus according to a second embodiment of the present invention will be described.

### Second Embodiment

The resin encapsulation apparatus according to the second embodiment has a structure which can further ensure that a resin flash is prevented from being formed on a surface of terminal 50a protruding from resin encapsulated body 77. It is noted that to avoid redundancy in the description, same members as those of the above-described resin encapsulation apparatus have the same reference characters allotted in Fig. 7.

Once the top mold and the bottom mold are clamped together, the tip end of external connection terminal 50, which is not fitted into molding cavity 61, 60 of top mold 22 and bottom mold 21, will be sandwiched between the mold surface of the top mold and the mold surface of the bottom mold, under a mold clamping pressure. As a result, after resin molding, the tip end of external connection terminal serves as terminal 50a for external connection which protrudes from resin encapsulated body 77 (see Fig. 6).

At this time, when the tip end of connection terminal 50 is under an appropriate mold clamping pressure applied by the top mold and the bottom mold, it can be prevented that a resin flash is formed through adhesion of part of a melted resin material (flowable resin) to a surface of terminal 50a. However, external connection terminal 50 varies in thickness. For this reason, for example, when the external connection terminal has a thickness less than a predetermined thickness, in clamping the top mold and the bottom mold together, a gap may develop between the tip end of the external connection terminal and the mold surface of the top mold or the mold surface of the bottom mold. If so, this gap may cause a resin flash to be formed through adhesion of part of the molten resin material to a surface of terminal 50a.

In the resin encapsulation apparatus according to the second embodiment, a resin flash adhesion preventing part having a pressing member is provided so that in clamping top mold 22 and bottom mold 21 together, no gap develops between a surface of terminal 50a protruding from resin encapsulated body 77 and the mold surface of top mold 22 or the mold surface of bottom mold 21. By bringing a pressing surface of the pressing member into contact with a surface of terminal 50a by means of elastic force, it can be prevented that part of a melted resin material adheres to the surface of terminal 50a.

As shown in Fig. 7, the resin flash adhesion preventing part 93 includes the pressing member 93a fitted into top mold 22 in a vertically movable manner and an elastic member 93b. Pressing member 93a is pushed out downward because of the elasticity of elastic member 93b. In clamping top mold 22 and bottom mold 21 together, a pressing surface 93c provided on the bottom end surface of pressing member 93a comes into contact with a surface (upper surface) of terminal 50a arranged on bottom mold 21, by means of elastic force.

It is noted that although Fig. 7 shows the resin encapsulation apparatus in which resin flash adhesion preventing part 93 is provided only at top mold 22, a resin flash adhesion preventing part having the same functions may also be provided at bottom mold 21. In this case, in clamping top mold 22 and bottom mold 21 together, pressing surfaces of the pressing members come into contact with the front surface (upper surface) and the back surface (lower surface) of terminal 50a, respectively, by means of elastic force.

With the resin encapsulation apparatus according to the second embodiment, pressing surface 93c of pressing member 93a comes into contact with a surface of terminal 50a by means of elastic force just before top mold 22 and bottom mold 21 are clamped together (the step of preventing adhesion of a resin flash).

This further ensures that a resin flash is prevented from being formed through adhesion of part of a melted resin material to a surface of terminal 50a protruding from resin encapsulated body 77.

While the description has been given on a case where a thermosetting resin material is used as a resin material in each embodiment above, a thermoplastic resin material may be employed.

In addition, as a resin material, resin materials in various shapes such as a granular resin material (granular resin), a liquid resin material (liquid resin), a powdered resin material having a prescribed particle size distribution (powdered resin), a powdery resin material (powdery resin), a pasty resin material (pasty resin), a tablet resin material (tablet resin), or the like can be employed.

Further, an epoxy-based resin material (epoxy resin) or a silicon-based resin material (silicon resin) may be employed as a resin material.

Further, in each embodiment above, as a technique for injecting flowable resin R into molding cavity 60, 61 and filling the molding cavity, a known method of injecting and filling can be used. For example, a transfer molding, an injection molding, or the like can be used.

When using a transfer molding, a resin tablet (epoxy-based resin material) supplied into a pot is heated to melt. By applying pressure to the melted resin material (flowable resin) with a plunger fitted into the pot, the melted resin material is injected via a resin path (a cull part, a runner, a gate) into molding cavity 60, 61 and fills the molding cavity.

After expiration of a predetermined period of time required for the melted resin material to set, a mold for resin molding (a top mold, a bottom mold) can be opened, thereby providing a resin encapsulated article encapsulating an electrical circuit component.

## Claims

1. A resin encapsulation method for encapsulating with a resin material (R), a substrate (40) and an external connection terminal (50) and for integrally connecting a resin molded article (10) with a resin encapsulated body (77), said resin encapsulated body (77) comprising said substrate (40) and said external connection terminal (50), said external connection terminal (50) being electrically connected to said resin molded article (10), the method comprising the steps of:
providing a mold for resin molding (20) comprising a top mold (22) and a bottom mold (21);
fitting said resin molded article (10) into a cavity provided in a mold surface of said bottom mold (21) and fitting said substrate (40) and said external connection terminal (50) into a molding cavity (60) provided in the mold surface of said bottom mold (21), said resin molded article (10), on the one hand, and said substrate (40) and said external connection terminal (50), on the other hand, being individually arranged in the cavity (30) and the molding cavity (60), respectively;
guiding said resin molded article (10) to a predetermined position in said cavity (30) by means of a first guiding member (70) provided at said bottom mold (21) and guiding said substrate (40) and said external connection terminal (50) to a predetermined position in said molding cavity (60) by means of a second guiding member (80) provided at said bottom mold (21);
using two fixing members (91) provided at said bottom mold (21) to support said external connection terminal (50), by guiding said external connection terminal (50) to a predetermined position in said bottom mold (21) and by pressing a constricted portion (51) formed on a lateral surface of said external connection terminal (50) against said fixing members (91);
clamping said top mold (22) and said bottom mold (21), the top mold (22) having a cavity (31) and a molding cavity (61) opposite to the cavity (30) and the molding cavity (60) of the bottom mold (21);
encapsulating said substrate (40) and said external connection terminal (50) fitted into said molding cavity (60, 61), by injecting said resin material (R) into said molding cavity (60, 61) formed by the mold clamping of said top mold (22) and said bottom mold (21) to fill said molding cavity (60, 61) in a manner to form said resin encapsulated body (77) encapsulating said substrate (40) and said external connection terminal (50) and to integrally connect said resin encapsulated body (77) and said resin molded article (10) so that a one-piece resin encapsulated molded article (10,77) is formed;
opening said mold (20) and removing, from said mold (20), said resin encapsulated body (77) and said resin molded article (10) that have been made into one piece (10,77).

2. The resin encapsulation method for an electrical circuit component according to claim 1, wherein:
clamping said top mold and said bottom mold for resin molding (20) includes bringing a pressing surface of a pressing member (93) provided at said top mold for resin molding (20) into contact with a front surface of said external connection terminal (50), by means of elastic force.

3. A resin encapsulation apparatus for encapsulating with a resin material (R) a substrate (40) and an external connection terminal (50) and for integrally connecting a resin molded article (10) with a resin encapsulated body (77), said resin encapsulated body (77) comprising said substrate (40) and said external connection terminal (50), said external connection terminal (50) being electrically connected to said resin molded article (10), the apparatus being equipped with a mold for resin molding (20), said mold for resin molding (20) comprising:
a bottom mold (21) with a cavity (30) and a molding cavity (60) and a top mold (22) having a cavity (31) and a molding cavity (61) opposite to the cavity (30) and the molding cavity (60) of the bottom mold (22);
the cavity (30, 31) between the bottom mold and the top mold to be fitted with said resin molded article (10);
the molding cavity (60, 61) between the bottom mold and the top mold to be fitted with said substrate (40) and said external connection terminal (50);
a first guiding member (70) to guide said resin molded article (10) to a predetermined position in said cavity (30, 31);
a second guiding member (80) to guide said substrate (40) and said external connection terminal (50) to a predetermined position in said molding cavity (60, 61); and
a pressing and supporting part (90) including two fixing members (91) provided at said bottom mold (21) and extending above the mold surface of said bottom mold said fixing members (91) being suitable for supporting said external connection terminal (50) by pressing a constricted portion (51) formed on a lateral surface of said external connection terminal (50) against said fixing members (91).

4. The resin encapsulation apparatus for an electrical circuit component according to claim 3, wherein:
said top mold for resin molding (20) comprises a first pressing member (93) having a pressing surface which comes into contact with a front surface of said external connection terminal (50) by means of elastic force.

5. The resin encapsulation apparatus for an electrical circuit component according to claim 4, wherein:
said bottom mold for resin molding (20) comprises a second pressing member having a pressing surface which comes into contact with a back surface of said external connection terminal (50) by means of elastic force.

## Patentansprüche

1. Harzverkapselungsverfahren zum Verkapseln eines Substrats (40) und eines externen Verbindungsanschlusses (50) mit einem Harzmaterial (R) und zum einteiligen Verbinden eines Harzformkörpers (10) mit einem mit Harz verkapselten Körper (77), wobei der mit Harz verkapselte Körper (77) das Substrat (40) und den externen Verbindungsanschluss (50) umfasst, wobei der externe Verbindungsanschluss (50) mit dem Harzformkörper (10) elektrisch verbunden ist, wobei das Verfahren die folgenden Schritte umfasst:
Bereitstellen einer Gießform für das Harzgießen (20), die eine obere Gießform (22) und eine untere Gießform (21) umfasst;
Einsetzen des Harzformkörpers (10) in einen Hohlraum, der in einer Gießformfläche der unteren Gießform (21) vorgesehen ist, und Einsetzen des Substrats (40) und des externen Verbindungsanschlusses (50) in einen Gießformhohlraum (60), der in der Gießformfläche der unteren Gießform (21) vorgesehen ist, wobei der Harzformkörper (10) einerseits und das Substrat (40) und der externe Verbindungsanschluss (50) andererseits jeweils einzeln in dem Hohlraum (30) und dem Gießformhohlraum (60) angeordnet sind;
Führen des Harzformkörpers (10) in eine vorgegebene Position in dem Hohlraum (30) mit Hilfe eines ersten Führungselements (70), das an der unteren Gießform (21) vorgesehen ist, und Führen des Substrats (40) und des externen Verbindungsanschlusses (50) in eine vorgegebene Position in dem Gießformhohlraum (60) mit Hilfe eines zweiten Führungselements (80), das an der unteren Gießform (21) vorgesehen ist;
Verwenden von zwei Befestigungselementen (91), die an der unteren Gießform (21) vorgesehen sind, um den externen Verbindungsanschluss (50) durch Führen des externen Verbindungsanschlusses (50) an eine vorgegebene Position in der unteren Gießform (21) und durch Drücken eines eingeschränkten Abschnitts (51), der auf einer seitlichen Fläche des externen Verbindungsanschlusses (50) gebildet ist, gegen die Befestigungselemente (91) zu tragen;
Festklemmen der oberen Gießform (22) und der unteren Gießform (21), wobei die obere Gießform (22) einen Hohlraum (31) und einen Gießformhohlraum (61) gegenüber dem Hohlraum (30) und dem Gießformhohlraum (60) der unteren Gießform (21) aufweist,
Verkapseln des Substrats (40) und des externen Verbindungsanschlusses (50), die in den Gießformhohlraum (60, 61) eingesetzt sind, durch Einspritzen des Harzmaterials (R) in den Gießformhohlraum (60, 61), der durch das Festklemmen der oberen Gießform (22) und der unteren Gießform (21) gebildet wird, um den Gießformhohlraum (60, 61) in einer Weise zu füllen, um den mit Harz verkapselten Körper (77), der das Substrat (40) und den externen Verbindungsanschluss (50) verkapselt, zu bilden und den mit Harz verkapselten Körper (77) und den Harzformkörper (10) einteilig zu verbinden, so dass ein einteiliger Harzformkörper (10, 77) gebildet wird;
Öffnen der Gießform (20) und Entfernen des mit Harz verkapselten Körpers (77) und des Harzformkörpers (10), die zu einem Teil (10, 77) gemacht wurden, aus der Gießform.

2. Harzverkapselungsverfahren für eine Komponente einer elektrischen Schaltung nach Anspruch 1, wobei
das Festklemmen der oberen Gießform und der unteren Gießform für das Harzgießen (20) enthält, eine Druckfläche eines Druckelements (93), das an der oberen Gießform für das Harzgießen (20) vorgesehen ist, mit Hilfe einer elastischen Kraft mit einer Vorderfläche des externen Verbindungsanschlusses (50) in Berührung zu bringen.

3. Harzverkapselungsvorrichtung zum Verkapseln eines Substrats (40) und eines externen Verbindungsanschlusses (50) mit einem Harzmaterial (R) und zum einteiligen Verbinden eines Harzformkörpers (10) mit einem mit Harz verkapselten Körper (77), wobei der mit Harz verkapselte Körper (77) das Substrat (40) und den externen Verbindungsanschluss (50) umfasst, wobei der externe Verbindungsanschluss (50) mit dem Harzformkörper (10) elektrisch verbunden ist, wobei die Vorrichtung mit einer Gießform zum Harzgießen (20) ausgestattet ist, wobei die Gießform für das Harzgießen (20) Folgendes umfasst:
eine untere Gießform (21) mit einem Hohlraum (30) und einem Gießformhohlraum (60) und eine obere Gießform (22) mit einem Hohlraum (31) und einem Gießformhohlraum (61) gegenüber dem Hohlraum (30) und dem Gießformhohlraum (60) der unteren Gießform (22);
den Hohlraum (30, 31) zwischen der unteren Gießform und der oberen Gießform, der mit dem Harzformkörper (10) auszustatten ist;
den Gießformhohlraum (60, 61) zwischen der unteren Gießform und der oberen Gießform, der mit dem Substrat (40) und dem externen Verbindunganschluss (50) auszustatten ist;
ein erstes Führungselement (70), um den Harzformkörper (10) in eine vorgegebene Position in dem Hohlraum (30, 31) zu führen;
ein zweites Führungselement (80), um das Substrat (40) und den externen Verbindungsanschluss (50) in eine vorgegebene Position in dem Gießformhohlraum (60, 61) zu führen, und
ein Druck- und Trageteil (90), das zwei Befestigungselemente (91) enthält, die an der unteren Gießform vorgesehen sind, und das sich über die Gießformfläche der unteren Gießform erstreckt, wobei die Befestigungselemente (91) geeignet sind, den externen Verbindungsanschluss (50) durch Drücken eines eingeschränkten Abschnitts (51), der auf einer seitlichen Fläche des externen Verbindungsanschlusses (50) gebildet ist, gegen die Befestigungselemente (91) zu tragen.

4. Harzverkapselungsvorrichtung für eine Komponente einer elektrischen Schaltung nach Anspruch 3, wobei:
die obere Gießform für das Harzgießen (20) ein erstes Druckelement (93) mit einer Druckfläche umfasst, die mit Hilfe einer elastischen Kraft mit einer Vorderfläche der Fläche des externen Verbindungsanschlusses (50) in Berührung kommt.

5. Harzverkapselungsvorrichtung für eine Komponente einer elektrischen Schaltung nach Anspruch 4, wobei:
die untere Gießform für das Harzgießen (20) ein zweites Druckelement mit einer Druckfläche umfasst, die mit Hilfe einer elastischen Kraft mit einer Rückseite des externen Verbindungsanschlusses (50) in Berührung kommt.

## Revendications

1. Procédé d'encapsulation en résine pour encapsuler par un matériau de résine (R) un substrat (40) et une borne de raccordement externe (50) et pour raccorder d'un seul tenant un objet (10) moulé en résine avec un corps (77) encapsulé en résine, ledit corps (77) encapsulé en résine comprenant ledit substrat (40) et ladite borne de raccordement externe (50), ladite borne de raccordement externe (50) étant raccordée électriquement audit objet (10) moulé en résine, le procédé comportant les étapes qui consistent à :
prévoir un moule permettant le moulage (20) en résine et comprenant un moule supérieur (22) et un moule inférieur (21),
placer ledit objet (10) moulé en résine dans une cavité prévue dans une surface de moulage dudit moule inférieur (21) et placer ledit substrat (40) et ladite borne de raccordement externe (50) dans une cavité de moulage (60) prévue dans la surface de moulage dudit moule inférieur (21), ledit objet (10) moulé en résine, d'une part, et ledit substrat (40) avec la borne de raccordement externe (50), d'autre part, étant agencés séparément, respectivement dans la cavité (30) et dans la cavité de moulage (60),
guider ledit objet (10) moulé en résine vers une position prédéterminée dans ladite cavité (30) au moyen d'un premier élément de guidage (70) prévu sur ledit moule inférieur (21) et guider ledit substrat (40) et ladite borne de raccordement externe (50) vers une position prédéterminée dans ladite cavité de moulage (60) au moyen d'un deuxième élément de guidage (80) prévu sur ledit moule inférieur (21),
utiliser deux éléments de fixation (91) prévus sur ledit moule inférieur (21) pour soutenir ladite borne de raccordement externe (50) en guidant ladite borne de raccordement externe (50) vers une position prédéterminée dans ledit moule inférieur (21) et en repoussant une partie rétrécie (51) formée sur une surface latérale de ladite borne de raccordement externe (50) contre lesdits éléments de fixation (91),
pincer ledit moule supérieur (22) et ledit moule inférieur (21), le moule supérieur (22) présentant une cavité (31) et une cavité de moulage (61) située face à la cavité (30) et à la cavité de moulage (60) du moule inférieur (21),
encapsuler ledit substrat (40) et ladite borne de raccordement externe (50) placée dans ladite cavité de moulage (60, 61) en injectant ledit matériau de résine (R) dans ladite cavité de moulage (60, 61) formée par le pinçage dudit moule supérieur (22) et dudit moule inférieur (21) pour remplir ladite cavité de moulage (60, 61), de manière à former ledit corps (77) encapsulé en résine qui encapsule ledit substrat (40) et ladite borne de raccordement externe (50) et raccorder d'un seul tenant ledit corps (77) encapsulé en résine et ledit article (10) moulé en résine de manière à former un objet moulé (10, 77) en une pièce encapsulé en résine et
ouvrir ledit moule (20) et enlever dudit moule (20) ledit corps (77) encapsulé en résine et ledit objet (10) moulé en résine qui ont été réunis en une seule pièce (10, 77).

2. Procédé d'encapsulation en résine d'un composant de circuit électrique selon la revendication 1, dans lequel
le pinçage dudit moule supérieur et dudit moule inférieur prévus pour le moulage (20) en résine comprend l'amenée d'une surface de poussée d'un élément de poussée (93) prévu sur ledit moule supérieur destiné à effectuer le moulage (20) en résine en contact avec une surface frontale de ladite borne de raccordement externe (50), au moyen d'une force élastique.

3. Appareil d'encapsulation en résine prévu pour encapsuler dans un matériau de résine (R) un substrat (40) et une borne de raccordement externe (50) et pour raccorder d'un seul tenant un objet (10) moulé en résine avec un corps (77) encapsulé en résine, ledit corps (77) encapsulé en résine comprenant ledit substrat (40) et ladite borne de raccordement externe (50), ladite borne de raccordement externe (50) étant raccordée électriquement audit objet (10) moulé en résine, l'appareil étant équipé d'un moule de moulage (20) de résine, ledit moule de moulage (20) de résine comportant :
un moule inférieur (21) doté d'une cavité (30) et d'une cavité de moulage (60) un moule supérieur (22) doté d'une cavité (31) et d'une cavité de moulage (61) située face à la cavité (30) et à la cavité de moulage (60) du moule inférieur (22),
la cavité (30, 31) située entre le moule inférieur et le moule supérieur étant destinée à recevoir ledit objet moulé (10),
la cavité de moulage (60, 61) située entre le moule inférieur et le moule supérieur étant destinée à recevoir ledit substrat (40) et ladite borne de raccordement externe (50),
un premier élément de guidage (70) qui guide ledit objet (10) moulé en résine vers une position prédéterminée dans ladite cavité (30, 31),
un deuxième élément de guidage (80) qui guide ledit substrat (40) et ladite borne de raccordement externe (50) vers une position prédéterminée dans ladite cavité (60, 61),
une pièce (90) de poussée et de soutien qui contient deux éléments de fixation (91) prévus sur ledit moule inférieur et s'étendant au-dessus de la surface de moulage dudit moule inférieur, lesdits éléments de fixation (91) pouvant soutenir ladite borne de raccordement externe (50) en repoussant une partie rétrécie (51) formée sur une surface latérale de ladite borne de raccordement externe (50) contre lesdits éléments de fixation (91).

4. Appareil d'encapsulation en résine pour un composant de circuit électrique selon la revendication 3, dans lequel ledit moule supérieur prévu pour le moulage (20) en résine comprend un premier élément de poussée (93) doté d'une surface de poussée qui entre en contact avec une surface frontale de ladite borne de raccordement externe (50), au moyen d'une force élastique.

5. Appareil d'encapsulation en résine pour un composant de circuit électrique selon la revendication 4, dans lequel ledit moule inférieur prévu pour le moulage (20) en résine comprend un deuxième élément de poussée qui présente une surface de poussée qui entre en contact avec une surface arrière de ladite borne de raccordement externe (50) au moyen d'une force élastique.
